# EUROPÄISCHE PATENTSCHRIFT

(11) **EP 2 198 470 B1**
(45) Veröffentlichungstag und Bekanntmachung des Hinweises auf die Patenterteilung: **16.07.2014**
(21) Anmeldenummer: 08804786.5
(22) Anmeldetag: 26.09.2008
(51) Int. Cl.: H01L 51/00, H01L 51/52

(54) **VERFAHREN ZUR HERSTELLUNG EINER ORGANISCHEN LEUCHTDIODE ODER EINER ORGANISCHEN SOLARZELLE**
METHOD FOR PRODUCTION OF AN ORGANIC LIGHT EMITTING DIODE OR OF AN ORGANIC SOLAR CELL
PROCEDE POUR PRODUIRE UNE DIODE ELECTROLUMINESCENTE ORGANIQUE OU UNE CELLULE SOLAIRE ORGANIQUE

(30) Priorität: 28.09.2007 DE 102007000791
(43) Veröffentlichungstag der Anmeldung: 23.06.2010
(73) Patentinhaber: Universität Köln, 50923 Köln (DE)
(72) Erfinder: MEERHOLZ, Klaus, 51503 Rösrath (DE); KLESPER, Heike, 51467 Bergisch Gladbach (DE)
(74) Vertreter: Gille Hrabal
(86) Internationale Anmeldenummer: PCT/EP2008/062908
(87) Internationale Veröffentlichungsnummer: WO 2009/043815

(56) Entgegenhaltungen:
- EP-A- 1 391 944
- WO-A-2005/109539
- DE-A1- 10 155 775
- US-A1- 2005 231 106

## Beschreibung

Die vorliegende Erfindung betrifft ein Herstellungsverfahren für eine elektronische Vorrichtung. Eine solche elektronische Vorrichtung ist aus der WO 2005/1 09539 bekannt. Beispiele für eine solche elektronische Vorrichtung sind ein optischer Detektor, eine Laserdiode, ein Field-Quenching-Device, ein optischer Verstärker, eine organische Solarzelle oder eine organische Leuchtdiode.

Eine organische Leuchtdiode, kurz OLED (Kurzform für engl. "organic light-emitting diode"), ist ein leuchtendes Bauelement aus organischen, halbleitenden Materialien. Die OLED-Technologie ist u.a. für die Bildschirmanwendung (z.B. Fernseher, PC-Bildschirme) gedacht. Ein weiteres Einsatzgebiet stellt die großflächige Raumbeleuchtung sowie Werbebeleuchtung dar. Aufgrund der nutzbaren Materialien ist die Verwendung der OLEDs als flächige Leuchtquellen, biegsames Display und als elektronisches Papier (E-paper) nur noch eine Frage der Zeit.

Ein OLED-Aufbau besteht aus mehreren dünnen organischen, Schichten. Dabei wird meist auf eine für Licht ganz oder teilweise transparente Anode (z. B. Indium-Zinn-Oxid, ITO vom englischen Indium-Tin-Oxide), die sich auf einem transparenten Substrat, so zum Beispiel auf einer Glasscheibe oder einer transparenten Schicht aus Kunststoff wie Polyethylenterephthalat (PET) befindet, eine Lochleitungsschicht (hole transport layer = HTL) aufgebracht. Zwischen der Anode und der Lochleitungsschicht wird abhängig von der Herstellungsmethode oft noch eine Schicht aus PEDOT/PSS (Poly(3,4-ethylendioxythiophen)/Polystyrolsulfonat, Baytron P) aufgebracht, die zur Absenkung der Injektionsbarriere für Löcher dient und außerdem die Oberfläche glättet. Auf die Lochleitungsschicht wird eine Schicht aufgebracht, die entweder den Farbstoff enthält (ca. 5-10 %) oder - selten - komplett aus dem Farbstoff (z. B. Aluminium-tris(8-hydroxychinolin) = Alq3) besteht. Diese Schicht bezeichnet man als Emitterschicht (emitter layer = EL). Auf diese wird in machen Fällen eine Elektronenleitungsschicht (electron transport layer = ETL) aufgebracht. Zum Abschluss wird eine Kathode (bestehend aus einem Metall oder Legierung mit geringer Elektronenaustrittsarbeit z. B. Calcium, Aluminium, Magnesium/Silber-Legierung) im Hochvakuum aufgedampft. Zur Verringerung der Injektionsbarriere für Elektronen wird zwischen Kathode und ETL oder Emitter eine sehr dünne Schicht an z.B. LiF oder CsF aufgedampft. Die Kathode kann abschließend aus Schutzgründen mit Silber oder mit Aluminium beschichtet sein. Das transparente Substrat kann aber auch an die Kathode grenzen. Dann ist die Kathode für Licht ganz oder teilweise transparent.

Eine organische Solarzelle (OSC = organic solar cell) ist ein photovolaisch aktives Bauelement aus organischen halbleitenden Materialien oder aus einer Mischung von organischen und anorganischen halbleitenden Materialien. Diese Bauteile werden für die Zukunft als preiswerte Alternativen zu anorganischen Solarzellenmaterialien gesehen.

Ein OSC-Aufbau besteht aus mehreren dünnen organischen oder z.T. auch anorganischen Schichten. Dabei wird meist auf eine für Licht ganz oder teilweise transparente Elektrode (z. B. Indium-Zinn-Oxid, ITO vom englischen Indium-Tin-Oxide), die sich auf einem transparenten Substrat, so zum Beispiel auf einer Glasscheibe oder einer transparenten Schicht aus Kunststoff wie Polyethylenterephthalat (PET) befindet, eine photovoltaisch aktive Schicht aufgebracht. Zwischen der Elektrode und der photovoltaisch aktiven Schicht wird abhängig von der Herstellungsmethode oft noch eine Schicht aus PEDOT/PSS (Poly(3,4-ethylendioxythiophen)/Polystyrolsulfonat, Baytron P) aufgebracht, die zur Anpassung der Energieniveaus zwischen der transparenten Elektrode und der photovoltaisch aktiven Schicht dient und außerdem die Oberfläche glättet. Die photovoltaisch aktive Schicht ist entweder eine Mischung aus einer Donor- und einer Akzeptorverbindung, oder eine Schichtfolge von Donor- und Akzeptorverbindungen. Ein gängiges Beispiel für eine Donor-Verbindung ist Poly-3-hexyl-thiophen (P3HT), ein Beispiel für eine Akzeptorverbindung ist Phenyl-C61-Butylsäure Methylester (PCBM). Es können noch weitere Zwischenschichten vorhanden sein. Zum Abschluss wird eine Elektrode bestehend aus einem Metall oder Legierung mit geringer Elektronenaustrittsarbeit (z. B. Calcium, Aluminium, Magnesium/SilberLegierung) im Hochvakuum aufgedampft. Die Elektrode kann abschließend aus Schutzgründen mit Silber oder mit Aluminium beschichtet sein.

Verfahren zur Herstellung solcher elektronischer Bauteile gehen beispielsweise aus den Druckschriften US 7,041,608, US 6,593,690 sowie US 7,018,713 hervor. Hieraus sind unter anderem elektrostatische Sprühverfahren zur Aufbringung von Schichten bekannt. Aus diesem Stand der Technik ist nicht bekannt, dass das Aufsprühen unter bestimmten Umständen zu praktikabel herstellbaren elektronischen Bauteilen führen kann, die eine besonders gute Auskopplungseffizienz ermöglichen.

Zur Erzeugung von Licht wird eine Spannung an die Elektroden angelegt. Die Elektronen werden nun von der Kathode injiziert, während die Anode die Löcher bereitstellt. Loch (= positive Ladung) und Elektron (= negative Ladung) driften aufeinander zu und treffen sich im Idealfall in der Emitterschicht, weshalb diese Schicht auch Rekombinationsschicht genannt wird. Die Elektronen und Löcher bilden einen gebundenen Zustand, den man als Exziton bezeichnet. Abhängig vom Mechanismus stellt das Exziton bereits den angeregten Zustand des Farbstoffmoleküls dar, oder der Zerfall des Exzitons stellt die Energie zur Anregung des Farbstoffmoleküls zur Verfügung. Dieser Farbstoff hat verschiedene Anregungszustände. Der angeregte Zustand kann in den Grundzustand übergehen und dabei ein Photon (Lichtteilchen) aussenden. Die Farbe des ausgesendeten Lichts hängt vom Energieabstand zwischen angeregtem und Grundzustand ab und kann durch Variation der Farbstoffmoleküle gezielt verändert werden. Verantwortlich für die Lichtwellenlänge ist der Abstand zwischen dem sogenannten HOMO- und LUMO, HOMO und LUMO entsprechen dem Valenz- und Leitungsband beim anorganischen Halbleiter.

Nachteilhaft tritt das erzeugte Licht wegen interner Totalreflexion überwiegend seitlich und nur ein geringerer Teil nach vorne aus der Glasscheibe oder der Kunststoffschicht aus. Da in der Regel nur das nach vorne austretende Licht von Nutzen ist, wird das erzeugte Licht nur zu einem kleinen Teil tatsächlich genutzt.

Um die Auskopplung von nutzbarem Licht zu verbessern, wird gemäß der EP 1 100 129 A2 vorgeschlagen, eine aus Aerogel bestehende Zwischenschicht mit niedrigem Brechungsindex vorzusehen, die sich zwischen dem transparenten Substrat und der transparenten Elektrode befindet. Die Lichtausbeute soll so verdoppelt werden können. Allerdings kann eine aus Aerogel bestehende Zwischenschicht nicht praktikabel hergestellt werden. Daher ist dieser Vorschlag nicht in die Praxis umgesetzt worden.

Um in einer praktikableren Weise Licht geeigneter auskoppeln zu können, wird gemäß der WO 2005/109539 A1 vorgeschlagen, eine organische Leuchtdiode der eingangs genannten Art vorzusehen, bei der sich eine poröse Pufferschicht mit niedrigem Brechungsindex zwischen der transparenten Elektrode und einer aus einem organischen Halbleiter bestehenden Schicht befindet. Die Größe der Poren liegt im Nanometerbereich. Um eine organische Halbleiterschicht aufbringen zu können, soll die Pufferschicht geschlossenporig sein. Die poröse Pufferschicht wird entweder durch Pyrogene erzeugt, die nach der Schichtbildung aus der Pufferschicht entfernt werden, oder durch Aufschäumen. Die poröse Pufferschicht soll aus einem Loch leitenden Material bestehen.

In der Praxis ist es gelungen, die aus der WO 2005/1 09539 A1 bekannte Pufferschicht mit einem Brechungsindex von 1,6 (wellenlängenabhängig) herzustellen und so die Lichtausbeute zu verbessern. Die Verbesserung ist jedoch gering. Pufferschichten mit einem niedrigeren Brechungsindex unterhalb von 1,6 konnten in die Praxis allerdings nicht umgesetzt werden, um so die Lichtausbeute weiter steigern zu können. Auch ist es nicht gelungen, eine poröse Pufferschicht praxisgerecht herzustellen. Beispielsweise können Poren durch Schäumen nicht praxisgerecht hergestellt werden, weil ein Schäumungsverfahren grundsätzlich zu ungleichmäßigen Schichtdicken führt. Es konnten also gewünschte Schichtdicken der Pufferschicht nicht reproduzierbar hergestellt werden. Die Erzeugung der Porosität mit Hilfen von Pyrogenen führte nicht zu Poren mit geeigneter Porengröße.

Aus der Druckschrift EP 1 391 944 A2 geht hervor, organische Polymerschichten von elektronischen Bauteilen durch Sprühen aufzutragen.

Der vorliegenden Erfindung liegt die Aufgabe zugrunde, eine elektronische Vorrichtung der eingangs genannten Art mit guter, nutzbarer Lichtaus- oder -einkopplung in der Praxis herstellen zu können.

Zur Lösung der Aufgabe wird ein Verfahren zur Herstellung einer elektronischen Vorrichtung angegeben, welches die Merkmale des Anspruchs 1 umfasst. Die elektronische Vorrichtung umfasst eine Kathode und eine Anode. Eine der beiden Elektroden ist vollständig oder teilweise durchlässig für Licht. Zwischen den beiden Elektroden befinden sich ein oder mehrere organische, halbleitende Schichten und eine weitere organische Pufferschicht. Die Pufferschicht kann ebenfalls eine organische halbleitende Schicht sein. Zur Aufbringung der Pufferschicht in poröser Form wird eine Lösung aufgesprüht. Die Lösung umfasst vorzugsweise ein polares Lösungsmittel und/ oder ein elektrisch leitfähiges Additiv. Außerdem umfasst die Lösung ein unpolares Lösungsmittel sowie ein organisches Material, welches durch das unpolare Lösungsmittel gelöst wird. Die aufzusprühende Lösung wird in einer Ausführungsform mit Hilfe eines elektrischen Feldes zerstäubt. Wenn ein organisches Material verwendet wird, das sich bereits im polaren Lösungsmittel löst, kann auf das unpolare Lösungsmittel verzichtet werden. Wichtig ist hier, dass das Material aus dem die Pufferschicht erzeugt werden soll, effizient zerstäubt werden kann.

Durch das Aussprühen des Materials, aus dem die Pufferschicht entsteht, wird erreicht, dass sehr genau und gleichmäßig die gewünschte Schichtdicke der Pufferschicht hergestellt werden kann, die insbesondere zwischen 50 bis 2000 nm, liegt regelmäßig aber wenigstens 200 nm dick ist oder aber 1500 nm micht überschreitet. Die jeweils optimale Schichtdicke wird durch den Brechungsindex der jeweiligen Schicht, sowie die Dicke und den Brechungsindex aller anderen im Bauteil vorhandenen Schichten bestimmt. Auch die Wellenlänge des Lichtes, das aus einer bestimmten Schicht ausgekoppelt (OLED), bzw. in diese eingekoppelt werden soll (Solarzelle) ist hierfür von großer Bedeutung. Es ist für den Fachmann leicht möglich, bei Kenntnis der wellenlängenabhängigen Brechungsindices und Absorptionen aller beteiligten Schichten, deren optimale Schichtdicke und deren optimalen Brechungsindex, die gegenseitig voneinander abhängig sind, zu berechnen. Aufgrund von konstruktiven und destruktiven Interferenzen ergeben sich für alle Brechungsindices mehrere optimale Schichtdicken.

Bevor die Lösung auf die herzustellende elektronische Schicht abgeschieden wird, wird die Lösung mit dem darin befindlichen organischen Beschichtungsmaterial elektrisch derart aufgeladen, dass die Lösung zerstäubt wird. Die dadurch erreichte sehr feine Verteilung des Beschichtungsmaterials trägt zu einer Morphologie der Pufferschicht bei, die den Brechungsindex herabzusetzen vermag, wie überraschend festgestellt wurde. Dies wiederum hat zur Folge, dass interne Reflexionsverluste gesenkt und Licht geeigneter in das elektronische Bauteil ein- und/ oder ausgekoppelt werden kann. Insgesamt wird so der Wirkungsgrad verbessert.

Die zu versprühende Lösung enthält Lösungsmittel, in denen das aufzubringende organische Material löslich ist. Die zu verwendenden Materialien sind häufig in unpolaren Lösungsmitteln löslich. Daher enthält die zu versprühende Lösung in der Regel ein unpolares Lösungsmittel.

Unpolare Lösungsmittel sind z.T. schlecht elektrisch leitfähig. Um die Lösung mit Hilfe eines elektrischen Feldes dennoch hinreichend elektrisch aufladen und so zerstäuben zu können, wird bei Bedarf ein polares Lösungsmittel oder ein elektrisch leitfähiges Additiv hinzugefügt, um durch Abstoßungskräfte die gewünschte Zerstäubung zu erreichen. Ein polares Lösungsmittel ist in manchen Fällen gegenüber einem Additiv zu bevorzugen, weil regelmäßig das organische Beschichtungsmaterial schlechter in einem polaren Lösungsmittel gelöst wird im Vergleich zum unpolaren. Es wurde festgestellt, dass diese Eigenschaft die Morphologie der Pufferschicht günstig beeinflusst, so dass der Brechungsindex in der Pufferschicht gesenkt wird, was eine verbesserte Ein- oder Auskopplung von Licht zur Folge hat.

In einer Ausführungsform enthält die Lösung ein flüchtiges Lösungsmittel und zwar insbesondere Chloroform, Dichlormethan, Acetonitril oder einen Alkohol und zwar besonders bevorzugt Ethanol oder Methanol. Die Lösungsmittel sollten so flüchtig sein, dass sie nach der Schichtherstellung entweder schon bei Raumtemperatur oder durch Erwärmen unterhalb der Zersetzungstemperatur des aufzubringenden organischen Materials aus der Schicht entfernt werden können. Zum Teil ist es vorteilhaft, wenn eines oder mehrere der in der Lösung enthaltenen Lösungsmittel schon nach oder beim Versprühen verdampfen. Hierdurch können bereits während des Sprühvorgangs oder auf dem Weg der Sprühtropfen zur besprühten Fläche Bestandteile weniger gut gelöst bzw. vorgebildet oder ausgefällt werden, wodurch die Morphologie der entstehenden Schicht beeinflusst wird. Hierdurch wird u.a. beeinflusst, ob die Schichtbestandteile mehr oder weniger trocken auf der zu besprühenden Fläche auftreffen. Auch durch die Entfernung zwischen einer eingesetzten Spraykapillare und zu besprühender Fläche wird der Lösungsmittelgehalt der sich annähernden Spraybestandteile beeinflusst. Auch der Lösungsmittelgehalt oder die Feuchtigkeit in der Atmosphäre, in der gesprüht wird, hat Einfluss auf die Morphologie der entstehenden Schicht.
Beispiele für eine Lösungsmittelmischung sind
90% Dichlormethan + 10% Ethanol
90% Toluol, + 10% Methanol
80% Chloroform +20% Ethanol

Die Verdampfung der Lösungsmittel kann vorteilhaft auch durch Erwärmen unterstützt werden. Es können auch heizbare Gasströme um die Sprühkapillare angeordnet werden, um so die Verdampfung der Lösungsmittel zu beeinflussen. Auch eine gezielte Einstellung des Lösungsmittelgehaltes und der Luftfeuchtigkeit in der Atmosphäre, in der gesprüht wird, ist vorteilhaft.

Es wurde festgestellt, dass die Morphologie der Pufferschicht so weiter im Sinne der Erfindung verbessert wird. Der Brechungsindex der Schicht sinkt weiter. Die gewünschte Ein- oder Auskopplung von Licht gelingt entsprechend verbessert.

Als unpolare Lösungsmittel eignen sich regelmäßig beispielsweise Toluol, Xylol, Chlorbenzol, Dichlorbenzol, Tetrahydrofuran. Chloroform oder Dichlormethan.
Als polare Lösungsmittel eignen sich Alkohole wie Ethanol, Methanol, Isopropanol, Acetonitril.

Als organisches Beschichtungsmaterial eignen sich die in der WO 2005/109539 A1 offenbarten Materialgruppen und Materialien der hieraus bekannten Pufferschicht. In einer Ausführungsform werden niedermolekulare, vernetzbare Lochleiter als organisches Beschichtungsmaterial vorgesehen, so zum Beispiel die nachfolgend gezeigte Struktur auf der Basis von Triarylamin mit Oxetan als reaktiver Gruppe:

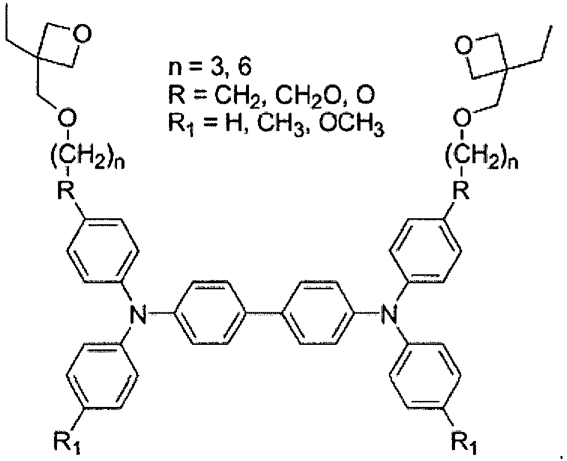

In einer anderen Ausführungsform der Erfindung werden niedermolekulare, oligomere oder polymere Lochleitermaterialien als organisches Beschichtungsmaterial vorgesehen, da so Produktionsbedingungen im Vergleich zu den niedermolekularen, vernetzbaren Lochleiter vereinfacht werden können. Ursächlich dafür sind die guten Filmbildungseigenschaften von oligomeren oder polymeren Lochleitermaterialien

Beispiele für niedermolekulare Lochleiter sind 4,4',4"-Tris(carbazol-9-yl)triphenylamin, α-NPD, Spiro-TAD, TPD, MTOATA, Carbazol-enthaltende Triplett-Matrices.

Nachfolgend wird die chemische Struktur von oligomeren, vernetzbaren Lochleitern auf der Basis von Triarylamin mit Oxetan als reaktiver Gruppe gezeigt.

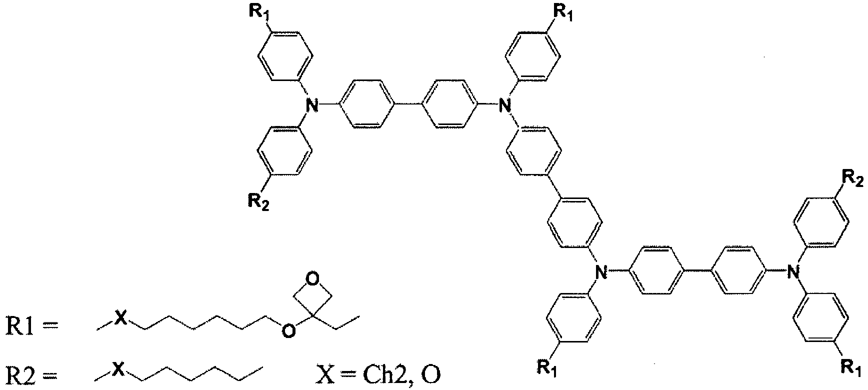

Nachfolgend wird die chemische Struktur von polymeren, vernetzbaren Lochleitern auf der Basis von Triarylamin mit Oxetan als reaktiver Gruppe gezeigt.

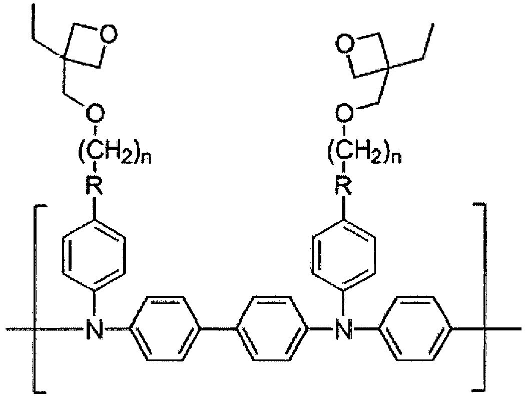

Eine anschließende Vernetzung von so hergestellten porösen Schichten erhöht die mechanische Stabilität und Belastbarekeit der hergestellten Schicht, was sich vorteilhaft für eine spätere praktische Anwendung auswirkt.

In einer anderen Ausführungsform wird ein intrinsich leitfähiges Polymer wie z.B. PEDOT oder Polyanilin zur Herstellung der Pufferschicht verwendet.

In einer anderen Ausführungsform werden niedermolekulare, oligomere und Polymere Emittermaterialien zur Herstellung der Pufferschicht verwendet.

Beispiele hierfür sind kleine Moleküle wie z.B. Tris-(8-hydroxy-chinolinato)-aluminium (Alq3), Tris(2-phenyl-pyridyl)iridium Komplex, Carbazolmatrix + Metallkomplex wie z.B. Ir(Py)₃, etc. oligomere Emitter oder polymere Emitter z.B auf Poly-Phenylen-Vinylen (PPV)-Basis oder auf Fluoren-Basis wie beipielsweise MEH-PPV, MDMO-PPV, Super Yellow.

In einer Ausführungsform werden niedermolekulare, oligomere oder polymere Elektrontransportmaterialien wie z.B. 2-(4-Biphenyl)-5-(4-tert-butyl-phenyl)-1,3,4-oxadiazol, 1,3,4-Oxadiazol 2,2'-(1,3-phenylen)bis(5-(1-(1,1-dimethylethyl)phenyl)), Polyfluorene, Fullerene wie z.B. PCBM oder PCBM-Multiaddukt etc. als organisches Beschichtungsmaterial vorgesehen.

In einer anderen Ausführungsform werden photovoltaisch aktive Materialien oder Materialmischungen zur Herstellung der Pufferschicht verwendet. Hierbei beispielsweise kommen Elektronenakzptormaterialien wie Fullerenderivate oder Elektronendonormaterialien wie Thiophenderivate oder andere N- oder S- Heterocyclen in Frage.

Beispiele für Elektronenakzeptormaterialien sind Fullerenderivate wie C₆₀, C₆₁-butyric acid methyl ester (PCBM), PCBM-Multiaddukt.

Beispiele für Elektronendonormaterialien sind Poly-(3-hexyl)-thiophen (P3HT), (MDMO-PPV), Farbstoffe wie Rylenfarbstoffe und Merocyaninfarbstoffe, Farbstoffe, die Metallkomplexe enthalten.

Die Zusammensetzung der Lösung, die zur Herstellung der Pufferschicht aufgesprüht wird, wird so gewählt, dass während des Versprühens das Lösungsmittel derart verdampft, dass das organische Material ausflockt und in einem halbtrockenen Zustand abgeschieden wird. Das organische Material hat sich dann derart verfestigt, dass es nicht zerfließt, wenn es abgeschieden wird. Auf der anderen Seite ist das organische Material nicht derart trocken, dass es zerbröselt und keine Haftung zwischen den einzelnen Teilchen erreicht werden kann. Es resultiert dann eine Morphologie der Pufferschicht, die einen relativ zur kompakten Schicht abgesenkten Brechungsindex aufweist und den Brechungsindex und somit die Ein- bzw. Auskopplung von Licht weiter in angestrebter Weise verbessert.

Je nach gewünschter Morphologie der Pufferschicht kann die Zusammensetzung der Lösung, die zur Herstellung der Pufferschicht aufgesprüht wird, so gewählt werden, dass das Lösungsmittel erst nach dem Versprühvorgang verdampft, und nur das bereits im gebildeten Tropfen vorhandene organische Material ausflockt und in einem halbtrockenen Zustand abgeschieden wird. Das organische Material liegt dann in Form besonders kleiner Partikel vor, wenn es abgeschieden wird. Es resultiert dann eine Morphologie der Pufferschicht, die besonders kleine Poren aufweist und einen relativ zur kompakten Schicht abgesenkten Brechungsindex aufweist. Der Brechungsindex und somit die Ein- bzw. Auskopplung von Licht werden weiter in angestrebter Weise verbessert.

In einer Ausgestaltung der Erfindung wird die Fläche, auf der das Beschichtungsmaterial aufgetragen werden soll, auf ein elektrisches Potezial gelegt, das auf die zu versprühende geladene Lösung anziehend wirkt.

Hierdurch werden Materialverluste durch Vorbeisprühen an der Fläche vermindert.

In einer Ausgestaltung der Erfindung wird die Fläche, auf der das Beschichtungsmaterial der Pufferschicht aufgetragen werden soll, elektrisch aufgeladen und zwar entgegengesetzt zu der zu versprühenden Flüssigkeit. Dadurch wird die elektrisch entgegengesetzt geladene Lösung, die organisches Material enthält, in Richtung Fläche gelenkt, die mit dem organischen Material beschichtet werden soll. Materialverluste werden so herabgesetzt,

Um Materialverluste weiter zu minimieren, wird die aufzusprühende Lösung in einer Ausführungsform elektrisch aufgeladen und die durch das Sprühen entstehende Sprühwolke durch zusätzliche elektrostatische und/ oder magnetische Felder geformt.

In einer weiteren Ausführungsform werden zur Formung der Sprühwolke gerichtete Gasströme verwendet.

In einer weiteren Ausgestaltung der Erfindung wird die Lösung mit dem darin befindlichen organischen Material über eine Kapillare oder eine Düse versprüht. Der Abstand zwischen der Kapillare bzw. der Düse und der zu beschichtendenden Fläche des elektronischen Bauteils wird während des Abscheidevorgangs verändert. Bei großem Abstand treffen eher trockene, bei kleinem Abstand eher nasse organische Partikel auf der zu beschichtenden Fläche auf. Werden die ersten Lagen mit einem großen Abstand und die späteren Lagen mit einem niedrigeren Abstand zwischen Fläche und Kapillare bzw. Düse aufgetragen, wird erreicht, dass die Oberfläche der so hergestellten Pufferschicht eine geschlossene Oberfläche aufweist und unter dieser Oberfläche die Morphologie so ist, dass hier der Brechungsindex niedrig ist. Die geschlossene Oberfläche ist von Nutzen, um hierauf eine weitere Schicht geeignet aufbringen zu können. Das Material dieser weiteren Schicht kann nicht unerwünscht in die Pufferschicht gelangen und deren Eigenschaft hinsichtlich des Brechungsindexes oder aber hinsichtlich ihrer Funktion negativ beeinträchtigen.

In einer weiteren Ausführungsform wird zunächst mit niedrigem Abstand zwischen Düse und Oberfläche gesprüht. Anschließend wird mit höherem Abstand und danach wieder geringerem Abstand beschichtet. Hierdurch wird zunächst eine kompaktere Schicht mit besonders guter Haftung und leitfähiger Verbindung zur besprühten Fläche erzeugt, anschließend die poröse Zwischenschicht mit reduziertem Brechungsindex und dann wieder eine glatte Deckschicht.

In einer weiteren Ausführungsform wird die Lösungsmittelzusammensetzung der zu versprühenden Lösung zunächst so gewählt, dass eine kompaktere Schicht mit besonders guter Haftung und leitfähiger Verbindung zur besprühten Fläche erzeugt wird, anschließend wird eine Zusammensetzung der Lösung verwendet, die eine poröse Zwischenschicht mit reduziertem Brechungsindex erzeugt. Anschließend kann dann wieder in der zuvor genannten Weise eine glatte Deckschicht erzeugt werden.

In einer weiteren Ausführungsform wird die Temperatur und/oder der Lösungsmittelgehalt der Atmosphäre, in der gesprüht wird, so variiert, dass es in analoger Weise wie oben zu Schichten mit variierendem Brechungsindex kommt. Z.B. entsteht so zuerst eine kompaketere Schicht, um eine gute Haftung auf der Unterlage zu erzielen, anschließend ein gradueller Übergang in eine poröse Schicht und dann wieder eine kompaktere Deckschicht.

Die verschiedenen Methoden, um kompakte und poröse Schichten zu erzeugen, können in beliebiger Weise miteinander kombiniert werden.

Eine anschließende Vernetzung der so hergestellten Schichten erhöht die mechanische Stabilität und Belastbarkeit, was sich vorteilhaft für eine spätere praktische Anwendung auswirkt.

Das aufgesprühte organische Material wird In einer Ausführungsform vernetzt, um einerseits die Schicht zu stabilisieren und andererseits die Leitfähigkeit (elektrische) heraufzusetzen. Wird eine nachfolgende Schicht in Form einer Lösung aufgebracht, die Lösungsmittel enthält, die die vorherige Schicht lösen kann" so ist die Vernetzung von Vorteil, damit verhindert wird, dass die Pufferschicht mangels Halt weggeschwemmt wird oder ihre Morphologie nachteilig ändert.

In einer Ausführungsform wird das aufgesprühte Material redoxchemisch dotiert, um seine Leitfähigkeit zusätzlich heraufzusetzen.

In einer Ausgestaltung der Erfindung besteht eine an die Anode angrenzende Pufferschicht aus Loch leitendem Material. Hierdurch wird vermieden, dass die Rekombination nahe bei der Anode stattfindet, da Elektronen in diese Lochtransportschicht nicht eindringen können. Eine Rekombination nahe bei der Anode würde die Lichtausbeute herabsetzen, was durch diese Ausgestaltung vermieden wird.

In einer Ausgestaltung der Erfindung ist das Material der Pufferschicht so gewählt, dass Injektionsbarrieren für Löcher oder Elektronen absenkt werden, um weniger Energie zu benötigen, um in die verschiedenen Schichten gelangen zu können. Die Leistungsfähigkeit des elektronischen Bauteils wird so verbessert

Eine typische Ausführungsform enthält dann beispielsweise eine Lochleiterschicht (z.B. OTPD, MUPD, AUPD, QUPD oder Mischungen davon) oder 2 jeweils halb so dicke Lochleiterschichten (als "elektronische Stufen").

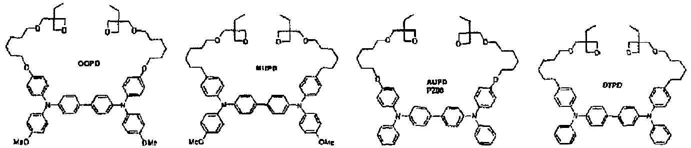

Darauf befindet sich ein blau emittierendes Polyfluoren. In einem Ausführungsbeispiel ist der Schichtaufbau folgendermaßen: Glas, 125 nm ITO, 30 nm PEDOT, 500 nm gesprühter poröser Lochleiter OTPD, 80 nm blau-emittierendes Fluorenpolymer, 4 nm Barium, 150 nm Silber. Gegenüber herkömmlichen Bauteilen ohne Lochleiterschichten wird so die Lichtausbeute um einen Faktor 2-5 gesteigert.

Ein erfindungsgemäßes elektronisches Bauteil umfasst grundsätzlich ein oder mehrere Emitterschichten - auch Rekombinationsschichten genannt -, die vorzugsweise räumlich in der Mitte zwischen den beiden Elektronen liegen, um so die Leistungsfähigkeit des Bauteils weiter zu optimieren.

An die Kathode grenzt in einer Ausgestaltung eine Elektronentransportschicht, die analog wie die Lochtransportschicht wirkt. Es handelt sich dabei in einer Ausgestaltung zugleich um eine Pufferschicht im Sinne der vorliegenden Erfindung, wenn vorgesehen ist, Licht durch die Kathode ein- oder austreten zu lassen. Die Lichtausbeute wird so verbessert.

In einer Ausgestaltung der Erfindung sind ein oder mehrere Emltterschichten Pufferschichten im Sinne der vorliegenden Erfindung, um so die Lichtausbeute zu verbessern.

In einer weiteren Ausgestaltung der Erfindung enthält die aufzusprühende Lösung Additive, die einen niedrigen Brechnungsindex besitzten. Dies können beispielsweise Verbindungen mit den nachfolgenden oder ähnlichen chemischen Strukturen sein. In diesen Verbindungen können einige oder alle H-Atome durch Fluor ersetzt sein. Ein höherer Fluorierungsgrad senkt den Brechungsindex noch weiter ab. Sie können vernetzbar sein (mit den gezeigten Oxetangruppen) aber auch nicht-vernetzbar.

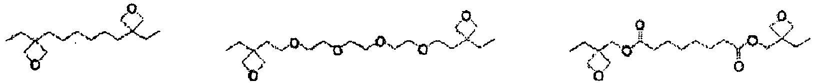

Es hat sich herausgestellt, dass hierdurch die gewünschte Ein- und Auskopplung von Licht weiter gesteigert werden kann.

Ein typisches Ausführungsbeispiel besteht aus der Schichtfolge Glas, 125 nm ITO, 30 nm PEDOT, 500 nm gesprühte poröse Lochleitermischung (75% OTPD + 25% fluoriertes Additiv), 80 nm blau-emittierendes Fluorenpolymer, Barium/Silber. Die Lichtauskopplung wird hierdurch gegenüber der oben genannten Variante ohne fluoriertes Additiv um 1 0 % gesteigert.

Die Leitfähigkeit der porösen Schichten kann bei Bedarf durch Redox-Dotierung erhöht werden.

In einer Ausgestaltung des Verfahrens wird das Sprühverfahren so durchgeführt, dass die Pufferschicht eine raue Oberfläche aufweist.

Ein typisches Ausführungsbeispiel besteht aus der Schichtfolge Glas, 125 nm ITO, 30nm PEDOT, 500 nm gesprühter poröser Lochleiter (75% OTPD + 25% fluoriertes und gegebenenfalls vernetzbares Additiv), 80 nm blau-emittierendes Fluorenpolymer, 4 nm Barium, 150 nm Silber. Die Rauhigkeit muss in der Größenordnung der Wellenlänge des emittierten Lichtes liegen (rms > 20 nm), um eine verbesserte Auskopplung zu erreichen. Eine entsprechende Rauhigkeit wird erzielt, indem die Spraybedingungen (Flüchtigkeit der Lösungsmittel, geheizter Gasstrom zur Unterstützung der Verdampfung des Lösungsmittels, Abstand zwischen Sprühkapillare und besprühter Fläche) so eingestellt werden, dass fast trockenes Lochleitermaterial auf der zu besprühenden Fläche auftrifft. Zunächst wird mit einer niedrig konzentrierten Lochleiterlösung gesprüht, damit die aus dem Sprühtropfen vorgebildeten Partikel möglichst klein sind. Später wird eine höhere Konzentration an Lochleitermaterial in der Sprühlösung verwendet, so dass die auf der zu beschichtenden Fläche auftreffenden vorgebildeten Lochleiterpartikel größer sind und so eine rauere Oberfläche erzeugen. Der Materialgehalt an Lochleiter+Additiv in in der versprühten Lösung betrug im Ausführungsbeispiel 4 g/l. Das Gemisch wurde aus einem Lösungsmittelgemisch von 10 %Methanol, 80% Toluol, 10% Tetrahydrofuran versprüht.

Dies erhöht die Effizienz bzw. Lichtausbeute weiter um ca. ca. Faktor 1,5 gegenüber der nicht rauen Schicht, die aus der sehr verdünnten Lösung aufgesprüht wurde.

Um zu einer weiter verbesserten Morphologie zu gelangen, wird in einer Ausgestaltung der Erfindung ein Gasstrom eingesetzt, der die aufzusprühende Lösung während des Versprühens umhüllt und zwar insbesondere in der aus der DE 101 55 775 A1 bekannten Weise mit der hieraus bekannten Vorrichtung. Dies verbessert weiter den Erhalt einer besonders geeigneten Morphologie der Pufferschicht, um so die Lichtausbeute in gewünschter Weise zu verbessern.

In einer anderen Ausgestaltung der Erfindung werden um eine Kapillare herum, mit der versprührt wird, angeordnete heizbare Gasströme verwendet, um die Morphologie der Pufferschicht und so die Lichtausbeute in gewünschter Weise zu verbessern. Als heizbare Gasströme werden vorteilhaft Gase verwendet, die das Auftreten von Corona-Gasentladungen verhindern oder zumindest nicht fördern. Verwendet werden können Gase wie zum Beispiel Luft, N₂, CO₂, SF₆ oder Mischungen davon.

In einer Ausgestaltung der Erfindung umfasst das elektronische Bauteil eine Mehrzahl von organischen Schichten, die insgesamt, also in der Summe, ca. 500 nm sind. Es kommt insbesondere dann darauf an, extrem gleichmäßig dicke Schichten herstellen zu können, Kanten und Verwerfungen bei einer Schicht sind zu vermeiden, um eine gleichmäßige Verteilung des elektrischen Feldes innerhalb des Schichtsystems zu erreichen. Diese Anforderungen vermag das erfindungsgemäße Verfahren trotz Vorhandenseins ein oder mehrerer poröser Schichten zu leisten. Dem Fachmann war bisher kein Weg bekannt, wie dieses Ziel erreicht werden konnte.

Dies gilt insbesondere auch für die industrielle Beschichtung großflächiger Substrate. Hier wird eine Vorrichtung mit entsprechend vielen Sprühköpfen versehen. Die Vorrichtung / die Sprayköpfe werden dann über die zu beschichtende Fläche verfahren und die Schicht wird aufgesprüht.

Das erfindungsgemäße Verfahren ist in der Lage, mit einer Vielzahl von abstandsverstellbaren Spraydüsen große Flächen auch in einem kontinuierlichen Prozess zu beschichten.

Beispielsweise beim Schäumungsverfahren müsste die zu schäumende Masse zwischen zwei Platten gebracht werden, um eine gewünschte glatte Oberfläche bereitzustellen. Die anschließende notwendige Abtrennung der Platte ist problematisch. Dies ist für einen industriellen Prozess undenkbar.

Das beanspruchte Verfahren kann in bestehende Herstellungssysteme integriert werden. Idealerweise erfolgt diese "Veredelung" der ITO-Scheiben in einem Zwischenschritt. Es ist keine große Umstellung erforderlich.

Das beanspruchte Verfahren bietet darüber hinaus die Möglichkeit, zunächst eine poröse Schicht aufzusprühen und dann die Parameter so abzuändern, dass die Porosität abnimmt. Hierbei kann zusätzlich auch schrittweise anderes Material (z.B. mit anderer Austrittsarbeit) aufgesprüht werden, um neben der Abstufung der Porosität auch eine Abstufung der Austrittsarbeiten in der Lochleiterschicht zu erhalten ("elektronische Stufen"). So wird schließlich eine glatte geschlossene oder beinah geschlossene Oberfläche bereitgestellt, auf der eine nächste Schicht aufgetragen werden kann, ohne dass diese nächste Schicht in die Poren eindringt. In vergleichbarer Weise kann auch ein langsamer Übergang von Lochleitermaterial zu Emittermaterial erzeugt werden.

Bei Solarzellen kann in vergleichbarer Weise zunächst reines Donormaterial aufgebracht werden, wobei nachfolgend im Verlauf des Schichtaufbaus zunehmend mehr Akzeptormaterial zugefügt wird, um dann den Anteil des Donormaterials zu reduzieren. Es resultiert die Schichtfolge Elektrode, Donor, Donor/Akzeptor-Gemisch, Akzeptor, Elektrode. Die Effizienz der Solarzelle kann so gesteigert werden.

Die eingangs genannten, aus dem Stand der Technik bereits bekannten Merkmale können grundsätzlich einzeln oder in Kombination miteinander auch Merkmale der vorliegenden Erfindung sein.

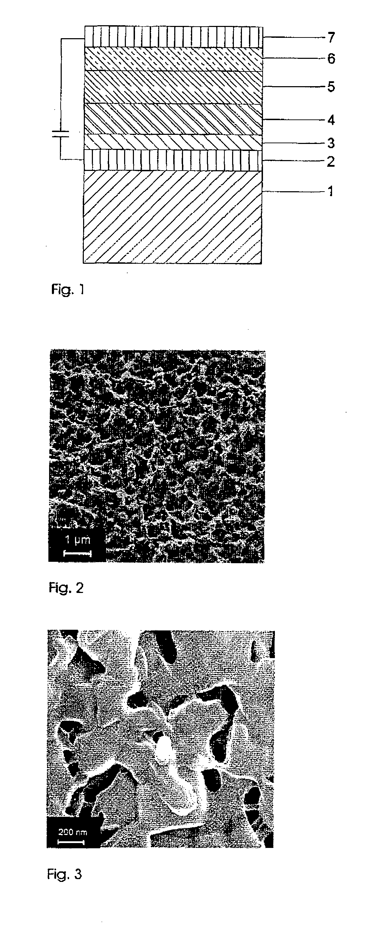

Fig. 1 zeigt schematisch den Aufbau einer organischen Leuchtdiode mit einer Glasscheibe 1, die als Substrat dient. Auf dem Substrat ist eine aus Indium-Zinn-Oxid bestehende transparente Anode 2 aufgebracht. Darauf befindet sich häufig noch eine PEDOT Schicht 3..Hierauf befindet sich eine gemäß dem beschriebenen Beispiel aufgetragene Lochleitungsschicht 4. Oberhalb der Lochleitungsschicht 4 ist eine Emitterschicht bzw. Rekombinationsschicht 5 aufgetragen. Auf der Ernitterschicht 5 befindet sich manchmal eine Elektronenleitungsschicht 6 und hierauf eine Kathode 7.

Die ITO-Schicht weist beispielsweise eine Schichtdicke von 140 nm auf und wird durch Sputtern aufgetragen. Diese Scheiben sind kommerziell als "Displayglas" erhältlich Die darüber befindliche PEDOT-Schicht mit ca. 10-200 nm Schichtdicke kann aus Lösung ausgeschleudert werden oder auch im Sinne dieser Erfindung als poröse Schicht aufgebracht werden. Die PEDOT-Schicht kann auch fortgelassen werden.
Darauf werden die Lochleiterschicht, die Emitterschicht und evtl. die Elektronenleiterschicht aufgebracht. Eine, beide oder alle Schichten können durch Sprühbeschichtung und damit mit reduziertem Brechungsindex gegenüber der analogen kompakten Schicht aufgetragen werden.
Die jeweils optimale Schichtdicke für jede dieser Schichten ergibt sich aus dem Brechungsindex der aufgetragenen Schicht, die wiederum z.B. durch ihre Porosität und den Gehalt an Brechungsindex-reduzierenden Additiven bestimmt wird. Weitere Faktoren, die die optimale Schichtdicke beeinflussen, sind die Schichtdicken und Brechungsindizes aller anderen Schichten im Bauteil, sowie bei OLEDs die emittierende Wellenlänge bzw. bei Solarzellen die zu absorbierende Wellenlänge.

Es Ist für den Fachmann leicht möglich, bei Kenntnis der wellenlängenabhängigen Brechungsindices und Absorptionen aller beteiligten Schichten, deren optimale Schichtdicke, die gegenseitig voneinander abhängig sind, zu berechnen. Aufgrund von konstruktiven und destruktiven Interferenzen ergeben sich für alle Brechungsindices mehrere optimale Schichtdicken.

Für die Schichtfolge Glas, 135 nm ITO, 35 nm PEDOT (gespincoated), Lochleiter QUPD, 50 nm grün emittierendes Polymer mit Brechungsindex n = 1,8 (kompakte Schicht, gespincoated), Kathode Ba/Ag, sind Schichtdicken einer gesprühten QUPD-Schicht mit einem Brechungsindex von 1,3 von 50 nm und 1 07 nm optimal. Für die Schichtfolge Glas, 135 nm ITO, 0 nm PEDOT, Lochleiter QUPD, 90 nm grün emittierendes Polymer mit Brechungsindex n = 1,3 (gesprüht), Kathode Ba/Ag, sind 118 nm einer gesprühten QUPD-Schicht mit einem Brechungsindex von 1,3 optimal.
Je nach den Randbedingungen des Schichtsystems liegen die optimalen Schichtdicken der gesprühten Schichten zwischen 1-1000 nm. Neben der aufgrund des Brechungsindex für die Auskopplung optimalen Schichtdicke ist zu beachten, dass die Schichten auch technisch herstellbar sein müssen.

Die Lochleiterschicht kann aus unterschiedlichen Materialien (mit abgestufter Austrittsarbeit) bestehen und / oder in ihrem Verlauf unterschiedlich porös sein.

Auf der Lochleiterschicht befindet sich die Emitterschicht mit typischen Schichtdicken von 20 - 800 nm (je nach Randbedingungen der Schichtfolge), die ihrerseits auch aufgesprüht sein kann, oder auch aufgeschleudert oder thermisch aufgedampft.

Auf der Emitterschicht befindet sich eine Elektronenleitungsschicht mit 0-500 nm Schichtdicke, die gesprüht, aufgeschleudert oder thermisch aufgedampft werden kann. Auch hier kann wie im Falle des Lochleiters die gesprühte Schicht aus unterschiedlichen Materialien (mit abgestufter Austrittsarbeit) bestehen und / oder in ihrem Verlauf unterschiedlich porös sein.

Über der Emitterschicht kann eine Elektronenleitungsschicht vorgesehen sein, auf der sich die Kathode befindet. Die Kathode besteht beispielsweise aus einem Alkalifluorid (z.B. LiF, CsF, etc) mit 0-10 nm, und darüber aus einem unedlen Metall (z.B. Ba, Ca) mit 0 - 150 nm. Darüber befindet sich ein Schutzmetall (z. B. Ag, Al) mit 0 -150 nm. Als Schutzschicht über der Kathode kann auch eine druckbare Elektrode verwendet werden. Die Kathode und die Schutzschichten können durch thermische Verdampfung, Sputtern, Elektronenstrahlverdampfung oder Drucken aufgebracht werden.

Alternativ kann auch die Reihenfolge der Schichten umgekehrt werden (Kathode auf Substrat, transparente Anode oben).

Für alle transparenten Schichten gilt, dass sich, wie oben bereits erwähnt, die jeweils optimale Schichtdicke für jede dieser Schichten aus dem Brechungsindex der aufgetragenen Schicht ergibt, die wiederum z.B. durch die chemische Struktur, ihre Porosität und den Gehalt an Brechungsindexreduzierenden Additiven bestimmt wird. Weitere Faktoren, die die optimale Schichtdicke beeinflussen sind die Schichtdicken und Brechungsindizes aller anderen Schichten im Bauteil, sowie bei OLEDs die emittierende Wellenlänge bzw. bei Solarzellen die zu absorbierende Wellenlänge. Es ist für den Fachmann leicht möglich, bei Kenntnis der wellenlängenabhängigen Brechungsindices und Absorptionen aller beteiligten Schichten, deren optimale Schichtdicke und deren optimalen Brechungsindex, die gegenseitig voneinander abhängig sind, zu berechnen. Aufgrund von konstruktiven und destruktiven Interferenzen ergeben sich für alle Brechungsindices mehrere optimale Schichtdicken.

Bei einem OLED-Bauteil der im folgenden beschriebenen Schichtfolge mit einer porösen Schicht wird gegenüber kompakten, d.h. herkömmlich durch Aufschleudern und nicht durch Aufsprühen aufgebrachte Schichten die Lichtauskopplung um einen Faktor 2 verbessert.
Schichtfolge: Glas, 73 nm ITO aufgesputtert, 0 nm PEDOT, 118 nm QUPD mit Brechungsindex n = 1,3 (gesprüht), 90 nm grün emittierendes Polymer mit Brechungsindex n = 1,3 (gesprüht), Kathode Ba/Ag. Eine weitere Absenkung der Brechungindices, wodurch auch eine neue Anpassung der jeweiligen Schichtdicken notwendig wird, führt zu einer weiteren Verbesserung der Lichtauskopplung.

Als Beispiel werden im Folgenden verwendete Parameter für die Sprühbeschichtung genannt:

Als Sprühkapillaren werden Edelstahlkapillaren mit 260 µm Außendurchmesser und 130 µm Innendurchmesser (Schnittenden entgratet und poliert) oder Quarzkapillaren mit Polyimid-Mantel (ebenfalls am Kapillarenende poliert) verwendet. Einzelne Sprühkapillaren werden zur Beschichtung kleiner Flächen verwendet. Bei der Beschichtung größerer Flächen werden Arrays von mehreren Sprühkapillaren benutzt, die in Reihen nebeneinander (5 St. Im Abstand von je 2 cm) und versetzt untereinander angeordnet sind.

Der Abstand zwischen Sprühkapillare/n und zu beschichtender Fläche ist variabel einstellbar zwischen 2 cm und 15 cm. Die anliegende Spannung ist vom Abstand zur beschichteten Fläche abhängig und liegt typischerweise zwischen 2 kV und 6 kV. Flussraten zur Flüssigkeitszufuhr zur Kapillare liegen im Bereich von 2-10 µl/min. Die eingesetzten Konzentrationen der Beschichtungssubstanzen richten sich danach, wie gut sie in den jeweiligen Lösungsmitteln löslich sind und ob eher viele sehr feine Poren (geringen Konzentration) oder wenige große Poren (höhere Konzentration) hergestellt werden sollen.

Ein Beispiel für eine Lösung ist 5 g/l Alq3 in einem Lösungsmittelgemisch von 90% Chloroform, 10%Ethanol. Als Additiv enthielt die Lösung 0,05% Ameisensäure. Der Abstand zwischen Spraykapillare und Substrat betrug 8 cm, die angelegte Spannung 5,6 kV, die Flußrate 3,5 µl/min.

Fig. 2 zeigt eine elektionenmikroksopische Aufnahme einer porösen Emitterschicht (AlQ3), die auf diese Weise hergestellt wurde

In Flg. 3 zeigt ein weiteres Beispiel eine elektronenmikroskopische Aufnahme einer porösen PEDOT-Schicht. Diese wurde unter folgenden Bediungen hergestellt. Eine kommerzielle wässrige Baytron P Dispersion wurde mit Ethanol im Verhältnis 1 :50 verdünnt. Der Abstand zwischen Spraykapillare und Substrat betrug 5 cm, die angelegte Spannung 5,4 kV, die Flußrate 5 µl/min.

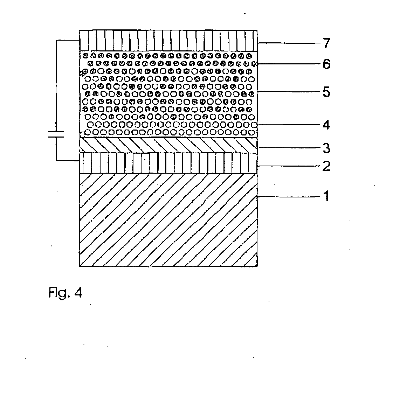

Fig. 4 zeigt schematisch den Aufbau einer organischen Solarzelle mit einer Glasscheibe 1, die als Substrat dient. Auf dem Substrat ist eine aus Indium-Zinn-Oxid bestehende transparente Elekrode 2 aufgebracht. Darauf befindet sich häufig noch eine PEDOT Schicht 3. Hierauf befindet sich eine gemäß der vorliegenden Erfindung aufgesprühte photovoltaisch aktive Schicht, die in ihrem Verlauf die Zusammensetzung ändert (Donor 4, Donor-Akzeptor-Gemisch 5, Akzeptor 6) und hierauf eine Elektrode 7.

## Patentansprüche

1. Verfahren zur Herstellung einer elektronischen Vorrichtung mit zwei Kontakten oder einer Kathode und einer Anode, von denen einer bzw. eine oder beide ganz oder teilweise durchlässig für Licht sind, mit einer oder mehreren organischen, halbleitenden Schicht und einer oder mehreren weiteren organischen Pufferschichten zwischen den Kontakten bzw. zwischen Kathode und Anode,
**dadurch gekennzeichnet, dass**
zur Aufbringung mindestens einer porösen Schicht eine Lösung aufgesprüht wird, die organisches Material enthält, wobei die Zusammensetzung der Lösung so gewählt wird, dass während des Versprühens das organische Material ausflockt und in einem halbtrockenen Zustand abgeschieden wird und dass das Lösungsmittel derart verdampft, dass das organische Material in einem derart verfestigten Zustand abgeschieden wird, dass es nicht zerfließt und nicht zerbröselt und keine Haftung zwischen den einzelnen Teilchen erreicht werden kann.

2. Verfahren nach Anspruch 1, **dadurch gekennzeichnet, dass** die aufzusprühende Lösung mit Hilfe eines elektrischen Feldes zerstäubt wird.

3. Verfahren nach Anspruch 1, bei dem die aufzusprühende Lösung als Lösungsmittel Toluol, Chlorbenzol, Dichlorbenzol, Xylol, Chloroform, Tetrahydrofuran, Ethanol, Methanol, Isopropanol, Chloroform oder Dichlormethan enthält.

4. Verfahren nach Anspruch 1, bei dem Lochleitermaterialien durch das Aufsprühen abgeschieden werden.

5. Verfahren nach Anspruch 1, bei dem das aufzusprühende Lösungsmittel als organisches Material niedermolekulare, polymere oder oligomere vernetzbare Lochleitermaterialien auf der Basis von Triarylamin mit Oxetan als reaktiver Gruppe oder andere oxetanvernetzbare Lochleitermaterialien enthält.

6. Verfahren nach Anspruch 1, bei dem Emittermaterialien versprüht werden, wie Singulettemitter, Triplettemitter, niedermolekulare Emitter, oligomere Emitter und polymere Emittermaterialien.

7. Verfahren nach Anspruch 1, bei dem Elektronenleitermaterialien durch das Aufsprühen abgeschieden werden

8. Verfahren nach Anspruch 1, bei dem photovoltaisch aktive Materialien oder Materialmischungen versprüht werden.

9. Verfahren nach Anspruch 1, bei dem Elektronenakzeptormaterialien wie Fullerenderivate oder Elektronendonormaterialien wie Thiophenderivate oder andere N- oder S- Heterocyclen versprüht werden.

10. Verfahren nach Anspruch 1, bei dem die aufzusprühende Lösung sowie die Fläche, auf der die Pufferschicht aufgetragen werden soll, eine elektrische Potenzialdifferenz aufweisen.

11. Verfahren nach Anspruch 1, **dadurch gekennzeichnet, dass** die Lösung mit dem darin befindlichen organischen Material über eine Kapillare oder eine Düse versprüht wird und der Abstand zwischen der Kapillare bzw. der Düse und der zu beschichtendenden Fläche des elektronischen Bauteils sich während des Schichtaufbaus verändert, wobei zunächst mit niedrigem Abstand zwischen Düse gesprüht wird, anschließend mit höherem Abstand und danach wieder mit geringerem Abstand.

12. Verfahren nach Anspruch 1 , **dadurch gekennzeichnet, dass** im Laufe des Schichtaufbaus die versprühte Lösung geändert wird, wodurch Schichten unterschiedlicher Materialien und/oder unterschiedlicher Brechungsindices abgeschieden werden.

13. Verfahren nach Anspruch 1, bei dem die Materialien durch Aufsprühen abgeschieden und anschließend vernetzt werden.

14. Verfahren nach Anspruch 1, bei dem die Fläche, auf der das Beschichtungsmaterial einer Pufferschicht aufgetragen werden soll, elektrisch aufgeladen wird und zwar entgegengesetzt zu der zu versprühenden Flüssigkeit.

## Claims

1. A method for production of an electronic device having two contacts or one cathode and one anode, whereof one both are completely or partially lightpermeable, having one or more semi-conductive organic layers and one or more organic buffer layers between the contacts or the cathode and the anode, respectively,
**characterised by** the fact, that
for the application of at least one porous layer a solution is sprayed on which contains organic material, wherein the composition of the solution is selected such that, during spraying, the organic materials flocculate and become deposited in a semi-dried state, and that the solvent evaporates such that the organic material becomes deposited in a solidified state such that it will not melt and will not crumble, and no adhesion may be achieved between the individual particles.

2. The method according to claim 1, **characterised by** the fact that the solution to be sprayed on is atomized by way of an electrical field.

3. The method according to claim 1, wherein the solution to be sprayed on as the solvent contains toluene, chlorobenzene, dichlorobenzene, xylene, chloroform, tetrahydrofurane, ethanol, methanol, isopropanol, chloroform or dichloromethane.

4. The method according to claim 1, wherein hole-conducting materials are deposited by spraying.

5. The method according to claim 1, wherein the solution to be sprayed on as the organic material contains crosslinkable polymeric or oligomeric hole-conducting materials of low molecular weight on the basis of triarylamine having oxetane as the reactive group or other oxetane-crosslinkable hole-conducting materials.

6. The method according to claim 1, wherein emitter materials are atomized such that the singlet emitters, the triplet emitters, the low molecular weight emitters, the oliogmeric emitters and the polymeric emitter materials.

7. The method according to claim 1, wherein the electron-conducting materials are deposited by spraying.

8. The method according to claim 1, wherein photovoltaically active materials or mixtures of photovoltaically active materials are sprayed.

9. The method according to claim 1, wherein electron acceptor materials such as fullerene derivatives electron donor materials such as thiophene derivatives or other N or S heterocycles are sprayed.

10. The method according to claim 1, wherein the solution to be sprayed as well as the surface, onto which the buffer layer is to be applied, have electrical potential difference.

11. The method according to claim 1, wherein the solution having organic material therein is sprayed through a capillary or a nozzle and the distance between the capillary or the nozzle, respectively, and the surface to be coated of the electronic component changes during layer formation, wherein spraying is first performed with a low distance from the nozzle, followed by a higher distance and then again with a lower distance.

12. The method according to claim 1, **characterised by** the fact that in the course of layer formation the solution to be sprayed is changed, thereby depositing layers of different materials and/or different refraction indices.

13. The method according to claim 1, wherein the materials are deposited by spraying and subsequently become crosslinked.

14. The method according to claim 1, wherein the surface, onto which the coating material of a buffer layer is to be coated, is electrically charged, i.e. oppositely to the solution to be sprayed.

## Revendications

1. Procédé pour produire un dispositif électronique ayant deux contacts ou une cathode et une anode, dont l'un ou l'une, respectivement, ou tous les deux sont complètement ou partiellement perméables à la lumière, ayant une ou plusieurs couches organiques semi-conductrices et une ou plusieurs couches de tampon organiques entre les contacts ou la cathode et l'anode, respectivement,
**caractérisé par le fait que**
pour l'application d'au moins une couche poreuse une solution est giclée qui contient du matériau organique, dans lequel la composition de la solution est choisie tel que, pendant le giclement, le matériau organiques flocule et est déposé dans une état demi-sec et que le solvant s'évapore tel que le matériau organique est déposé dans un tel état solidifié, qu'il ne fond pas et n'émiette pas et aucune adhésion peut être accomplie entre les particules individuelles.

2. Procédé selon la revendication 1, **caractérisé par le fait que** la solution à gicler est atomisée grâce à un champ électrique.

3. Procédé selon la revendication 1, dans lequel la solution à gicler en tant que solvant contient le toluène, le chlorobenzène, le dichlorobenzène, le xylène, le chloroforme, le tétrahydrofurane, l'éthanol, le méthanol, l'isopropanol, le chloroforme ou le dichlorométhane.

4. Procédé selon la revendication 1, dans lequel des matériaux conducteurs de trous sont déposés par le giclement.

5. Procédé selon la revendication 1, dans lequel la solution à gicler en tant que matériau organique contient des matériaux conducteurs de trous polymères ou oligomères réticulables de faible poids moléculaire à base de triarylamine avec de l'oxétane en tant que groupe réactif ou d'autres matériaux conducteurs de trous réticulables par l'oxétane.

6. Procédé selon la revendication 1, dans lequel des matériaux émetteurs sont atomisés, tel que les émetteurs de singulet, les émetteurs de triplet, les émetteurs de faible poids moléculaire, les émetteurs oligomériques et les matériaux émetteurs polymériques.

7. Procédé selon la revendication 1, dans lequel les matériaux conducteurs d'électrons sont déposés par giclement.

8. Procédé selon la revendication 1, dans lequel des matériaux photovoltaiquement actifs ou des mélanges de matériaux photovoltaiquement actifs sont giclés.

9. Procédé selon la revendication 1, dans lequel des matériaux accepteurs d'électrons tel que les dérivés de fullerène ou des matériaux donneurs d'électrons tel que les dérivés de thiophène ou d'autres hétérocycles de N ou S sont giclés.

10. Procédé selon la revendication 1, dans lequel la solution à gicler ainsi que la surface, sur laquelle la couche de tampon est à appliquer, ont une différence de potentiel électrique.

11. Procédé selon la revendication 1, dans lequel la solution avec le matériau organique là-dedans est giclé par une capillaire ou un gicleur et la distance entre la capillaire et le gicleur, respectivement, et la surface à revêtir du composant change pendant la formation de couche, dans lequel le giclement est d'abord mis en oeuvre avec une distance faible au gicleur, et ensuite avec une distance plus haute et puis avec une distance plus faible de nouveau.

12. Procédé selon la revendication 1, **caractérisé par le fait qu'**au cours de la formation de couche la solution giclée est changée, en déposant de ce fait des couches de différents matériaux et/ou de différents indices de réfraction.

13. Procédé selon la revendication 1, dans lequel les matériaux sont déposés par giclement et ensuite sont reticulés.

14. Procédé selon la revendication 1, dans lequel la surface, sur laquelle le matériau de revêtement d'une couche de tampon est à revêtir, est rechargée électriquement, à savoir opposée à la solution à gicler.
